(19) Europäisches Patentamt
European Patent Office
Office européen des brevets

(11) **EP 3 079 016 B1**

(12) **EUROPÄISCHE PATENTSCHRIFT**

(45) Veröffentlichungstag und Bekanntmachung des Hinweises auf die Patenterteilung:
**29.06.2022 Patentblatt 2022/26**

(21) Anmeldenummer: **16000776.1**

(22) Anmeldetag: **05.04.2016**

(51) Internationale Patentklassifikation (IPC):
**G03F 7/20** *(2006.01)*     **G02B 7/02** *(2021.01)*
**G02B 27/00** *(2006.01)*

(52) Gemeinsame Patentklassifikation (CPC):
**G03F 7/70266; G03F 7/705**

(54) **STEUERUNGSVORRICHTUNG ZUR STEUERUNG MINDESTENS EINES MANIPULATORS EINES PROJEKTIONSOBJEKTIVS**

CONTROL DEVICE FOR THE CONTROL OF AT LEAST ONE MANIPULATOR OF A PROJECTION LENS

DISPOSITIF DE COMMANDE D'AU MOINS UN MANIPULATEUR D'UN OBJECTIF DE PROJECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.04.2015 DE 102015206448**

(43) Veröffentlichungstag der Anmeldung:
**12.10.2016 Patentblatt 2016/41**

(73) Patentinhaber: **Carl Zeiss SMT GmbH**
**73447 Oberkochen (DE)**

(72) Erfinder: **RIST, Stefan**
**73430 Aalen (DE)**

(74) Vertreter: **Zeuner Summerer Stütz**
**Patent- und Rechtsanwälte**
**Partnerschaft**
**Nußbaumstraße 8**
**80336 München (DE)**

(56) Entgegenhaltungen:
WO-A1-2010/034674     WO-A1-2014/000763
DE-B3-102012 205 096     US-A1- 2011 205 510

**Beschreibung**

Hintergrund der Erfindung

Die Erfindung betrifft eine Steuerungsvorrichtung sowie ein Verfahren zur Steuerung mindestens eines Manipulators eines Projektionsobjektivs für die Mikrolithographie. Weiterhin betrifft die Erfindung eine Justieranlage zur Justierung eines Projektionsobjektivs für die Mikrolithographie sowie eine Projektionsbelichtungsanlage für die Mikrolithographie, jeweils mit einer derartigen Steuerungsvorrichtung.

Eine Projektionsbelichtungsanlage für die Mikrolithographie dient bei der Herstellung von Halbleiter-Bauelementen der Erzeugung von Strukturen auf einem Substrat in Gestalt eines Halbleiterwafers. Dazu umfasst die Projektionsbelichtungsanlage ein mehrere optische Elemente aufweisendes Projektionsobjektiv zum Abbilden von Maskenstrukturen auf den Wafer während eines Belichtungsvorganges.

Zur Gewährleistung einer möglichst präzisen Abbildung der Maskenstrukturen auf den Wafer wird ein Projektionsobjektiv mit möglichst geringen Wellenfrontaberrationen benötigt. Projektionsobjektive werden daher mit Manipulatoren ausgestattet, die es ermöglichen Wellenfrontfehler durch Zustandsveränderung einzelner optischer Elemente des Projektionsobjektivs zu korrigieren. Beispiele für eine derartige Zustandsveränderung umfassen: eine Lageänderung in einem oder mehreren der sechs Starrkörperfreiheitsgrade des betreffenden optischen Elements, eine Beaufschlagung des optischen Elements mit Wärme und/oder Kälte, eine Deformation des optischen Elements oder eine Materialabtragung an einem optischen Element mittels einer Nachbearbeitungseinrichtung. Im Rahmen dieser Anmeldung wird auch eine derartige Nachbearbeitungseinrichtung als Manipulator des Projektionsobjektivs im allgemeinen Sinn verstanden.

Die Berechnung von zur Korrektur einer Aberrationscharakteristik eines Projektionsobjektiv auszuführenden Manipulatorveränderungen erfolgt mittels eines stellwegsgenerierenden Optimierungsalgorithmus, welcher auch "Manipulatorveränderungsmodell" bezeichnet wird. Derartige Optimierungsalgorithmen sind beispielsweise in WO 2010/034674 A1 beschrieben.

So können aus dem Stand der Technik bekannte Optimierungsalgorithmen zur Lösung des folgenden Optimierungsproblems konfiguriert sein:

$$\min \left\| Mx - b_{mess} \right\|_2^2$$

$$\text{mit } NB : F_i(x) \le spec_x^i$$

Ein derartiges Optimierungsproblem ist dazu konfiguriert, die durch $\left\| Mx - b_{mess} \right\|_2^2$ beschriebene Gütefunktion, auch Meritfunktion bezeichnet, unter Berücksichtigung von durch $F_i(x) \le spec_x^i$ beschriebenen Nebenbedingungen zu minimieren. Hierbei bezeichnet M eine Sensitivitätsmatrix, x einen Stellwegvektor mit Stellwegen für die einzelnen Manipulatoren, $b_{mess}$ einen Zustandsvektor des Projektionsobjektivs, welcher eine gemessene Aberrationscharakteristik des Projektionsobjektivs beschreibt, $\| \ \|_2$ die Euklidische Norm und $spec_x^i$ einen jeweiligen festen Grenzwert für einzelne Stellwege $x_i$.

Unter "Stellweg" wird eine mittels Manipulator-Aktuierung erfolgende Veränderung einer Zustandsgröße eines optischen Elements entlang des Stellwegs zum Zweck der Veränderung seiner optischen Wirkung verstanden. Ein derartiger, durch Veränderung einer Zustandsgröße des optischen Elements definierter Stellweg wird über Solländerungsgrößen des zugehörigen Manipulators spezifiziert. Die Manipulation kann beispielsweise in einer Verlagerung des optischen Elements in eine spezielle Richtung, aber auch beispielsweise in einer, insbesondere lokalen oder flächigen, Beaufschlagung des optischen Elements mit Wärme, Kälte, Kräften, Licht einer bestimmten Wellenlänge oder Strömen bestehen. Weiterhin kann die Manipulation eine mittels einer Nachbearbeitungseinrichtung vorzunehmende Materialabtragung an einem optischen Element definieren. Die Solländerungsgröße kann beispielsweise im Falle einer Verlagerung eine zurückzulegende Weglänge oder einen zurückzulegenden Winkelbereich definieren.

Die durch $F_i(x) \le spec_x^i$ definierten Nebenbedingungen geben harte Verfahrwegsgrenzen für die Manipulatoren vor, die nicht überschritten werden dürfen. Das damit generierte Optimierungsergebnis in Gestalt eines Stellwegbefehls ist nicht für alle Manipulatorkonfigurationen optimal.

In DE 10 2012 205 096 B3 wird eine Projektionsbelichtungsanlage für die Mikrolithographie beschrieben, welche ein mehrere optische Elemente umfassendes Projektionsobjektiv zum Abbilden von Maskenstrukturen auf ein Substrat während eines Belichtungsvorgangs sowie mindestens einen Manipulator umfasst, welcher dazu konfiguriert ist, im Rahmen einer Manipulatoraktuierung die optische Wirkung mindestens einer der optischen Elemente innerhalb des Projektionsobjektivs durch Veränderung einer Zustandsgröße des optischen Elements entlang eines vorgegebenen Stellwegs zu verändern.

## Zugrunde liegende Aufgabe

Es ist eine Aufgabe der Erfindung, eine Steuerungsvorrichtung sowie ein Verfahren der eingangs genannten Art bereitzustellen, womit die vorgenannten Probleme gelöst werden, und insbesondere die Qualität eines damit generierten Stellwegbefehls verbessert werden kann.

## Erfindungsgemäße Lösung

Die vorgenannte Aufgabe kann erfindungsgemäß beispielsweise gelöst werden mit einer Steuerungsvorrichtung zur Steuerung mindestens eines Manipulators eines Projektionsobjektivs für die Mikrolithographie. Die Steuerung des mindestens einen Manipulators erfolgt durch Generierung eines Stellwegbefehls, welcher eine vorzunehmende Veränderung einer optischen Wirkung mindestens eines optischen Elements des Projektionsobjektivs durch Manipulation einer Eigenschaft des optischen Elements mittels des mindestens einen Manipulators entlang eines Stellweges definiert. Die Steuerungsvorrichtung ist dazu konfiguriert, aus einer Zustandscharakterisierung des Projektionsobjektivs den Stellwegbefehl für den mindestens einen Manipulator durch Optimierung einer Gütefunktion zu generieren. Die Gütefunktion umfasst dabei eine Linearkombination mindestens zweier Potenzen. Eine die Manipulation der Eigenschaft des optischen Elements definierende Einstellung des mindestens einen Manipulators wird mittels einer Stellwegvariablen dargestellt und die jeweilige Basis der mindestens zwei Potenzen enthält eine Funktion der Stellwegvariablen. Weiterhin weisen die Exponenten der mindestens zwei Potenzen unterschiedliche Werte auf.

Das genannte Projektionsobjektiv umfasst mehrere optische Elemente und dient im Betrieb einer das Projektionsobjektiv umfassenden Projektionsbelichtungsanlage zur Abbildung von Maskenstrukturen aus einer Maskenebene auf einen in einer Waferebene der Projektionsbelichtungsanlage angeordneten Wafer. Die Steuerungsvorrichtung kann auch als Stellwegsermittler bezeichnet werden.

Die Stellwegvariable kann als skalare Variable zur Darstellung lediglich einer Manipulatoreinstellung oder als vektorielle Variable zur Darstellung der Einstellungen mehrerer Manipulatoren vorliegen. Der Stellwegbefehl umfasst mindestens einen von dem mindestens einen Manipulator auszuführenden Stellweg. Dabei erfolgt die Ausführung des Stellwegs durch Manipulation einer Eigenschaft des optischen Elements entlang des Stellwegs. Die Gütefunktion, welche auch als "Meritfunktion" bezeichnet werden kann, umfasst eine Linearkombination, insbesondere eine Summe mindestens zweier Potenzen. Mit anderen Worten umfasst die Gütefunktion mindestens zwei Summanden, die ggf. bei der Summierung gewichtet werden können, und die jeweils durch eine Potenz gebildet sind. Gemäß der allgemein in der Mathematik gültigen Definition weist jede der Potenzen eine Basis und einen Exponenten auf.

Die jeweilige Basis der beiden Summanden enthält eine Funktion der Stellwegvariablen. Die Werte der Exponenten der mindestens zwei Potenzen unterscheiden sich voneinander. Durch die Zuweisung unterschiedlicher Werte an die Exponenten kann die Gütefunktion derart gestaltet werden, dass Zielwerte für mindestens zwei unterschiedliche, bei der Optimierung relevante, Größen mit unterschiedlichen, gezielt ausgewählten, Widerstandseigenschaften versehen werden. Derartige Größen können z.B. Verfahrwegsgrenzen von Manipulatoren, mittels mechanischer Nachbearbeitung erfolgende Materialabtragung an optischen Elementen des Projektionsobjektivs, Bildfehler des Projektionsobjektivs, Fading-Aberrationen des Projektionsobjektivs oder Overlay-Fehler des Projektionsobjektivs umfassen. Unter einer Widerstandseigenschaft eines Zielwerts wird verstanden, wie genau der Zielwert bei der Optimierung einzuhalten ist.

Ein Zielwert, der eine unbedingt einzuhaltende Grenze oder eine Grenze darstellt, von der nur minimal abgewichen werden darf, weist in diesem Fall eine maximale Widerstandseigenschaft auf und wird in diesem Zusammenhang als "harter" Zielwert bezeichnet. Ein Zielwert, der zwar idealerweise eingehalten werden soll, von dem jedoch auch Abweichungen toleriert werden können, wenn dafür andere Eigenschaften der Optimierung, insbesondere andere Zielwerte, besser erfüllt werden, wird in diesem Zusammenhang als "weicher" Zielwert bezeichnet.

Die unterschiedlichen Potenzen der Gütefunktion können Gütefunktionskomponenten bzw. Teilgütefunktionen definieren, die jeweils eine andere der vorstehend genannten, unterschiedlichen, bei der Optimierung relevanten Größen mit zugeordneten Zielwerten in Bezug setzen. Durch das erfindungsgemäße Vorsehen unterschiedlicher Werte für die Exponenten der mindestens zwei Potenzen der Gütefunktion ist es möglich, die Zielwerte der unterschiedlichen Größen mit unterschiedlichen Widerstandseigenschaften zu versehen und damit die Signifikanz der Größen in der Optimierung gezielt zu steuern. Insbesondere können die verschiedenen Größen unterschiedlich gewichtet werden. Mit anderen Worten kann gezielt zwischen wichtigeren und unwichtigeren Größen in der Optimierung unterschieden werden. Damit wird die Qualität der Optimierungsergebnisse und damit die Brauchbarkeit des generierten Stellwegbefehls verbessert.

Gemäß einer Ausführungsform ist die Steuerungsvorrichtung zur Steuerung des mindestens einen Manipulators eines zum Betrieb im EUV-Wellenlängenbereich konfigurierten Projektionsobjektivs ausgebildet.

Gemäß einer weiteren Ausführungsform nach der Erfindung weisen die mindestens zwei Potenzen unterschiedliche Basen auf. Damit können durch gezielte Anpassung der Basen Widerstandseigenschaften der bei der Optimierung relevanten Größen noch feiner und gezielter eingestellt werden. Die gezielte Anpassung der Basen kann beispielsweise durch geeignete Wahl von Gewichtungsparametern der den Größen zugeordneten Zielwerten erfolgen. Gemäß einer alternativen Ausführungsform weisen die mindestens zwei Potenzen mit unterschiedlichen Exponenten die gleiche Basis auf. Dies kann z.B. im Rahmen der Konfiguration der Gütefunktion als Taylorreihenentwicklung erfolgen.

Gemäß einer weiteren Ausführungsform weisen die Exponenten der mindestens zwei Potenzen Werte von jeweils größer oder gleich zwei auf. Damit weisen die Exponenten der mindestens zwei Potenzen unterschiedliche Werte von jeweils größer oder gleich zwei auf. Gemäß einer Ausführungsvariante weisen die Exponenten der mindestens zwei Potenzen Werte von jeweils größer oder gleich drei, insbesondere von größer oder gleich vier bzw. von größer oder gleich fünf auf. Durch die entsprechende Wahl der Werte der Potenzen ergibt sich ein gewisses Mindestmaß für die Steilheit der auf die jeweilige Potenz zurückgehenden Komponente der Gütefunktion und damit eine verbesserte Einhaltung von Zielwerten, die den bei der Optimierung relevanten Größen zugeordnet sind.

Gemäß einer weiteren Ausführungsform enthält die jeweilige Basis der mindestens zwei Potenzen jeweils einen Quotienten, dessen Zähler einen die Funktion der Stellwegvariablen enthaltenden Term umfasst und dessen Nenner einen Zielwert für den Term des Zählers sowie einen Gewichtungsfaktor für den Zielwert aufweist. Gemäß einer Ausführungsvariante weist der Gewichtungsfaktor einen Wert von mindestens 0,5 auf, insbesondere liegt der Wert zwischen 0,5 und 2,0. Gemäß einer Ausführungsform liegt der Gewichtungsfaktor der Basis der ersten Potenz im Bereich von 0,5 bis 2,0 und der Gewichtungsfaktor der Basis der zweiten Potenz liegt im Bereich von 0,6 und 0,95. Die erste Potenz bildet damit zumindest eine Komponente einer Teilgütefunktion mit einem "weichen" Zielwert, während die zweite Potenz zumindest eine Komponente einer Teilgütefunktion mit einem "harten" Zielwert bildet. Die gesamte Gütefunktion gewichtet damit zumindest zwei Zielwerte entsprechend unterschiedlich.

Gemäß einer weiteren Ausführungsform weist die Gütefunktion zumindest eine Komponente auf, die eine konvexe oder eine konkave Funktion der Stellwegsvariablen ist. Insbesondere ist die gesamte Gütefunktion eine konvexe oder eine konkave Funktion der Stellwegsvariablen.

Gemäß einer weiteren Ausführungsform beträgt eine Differenz der Werte der beiden Exponenten mindestens 5, insbesondere mindestens 10. Gemäß einer Ausführungsvariante weist der Exponent der ersten Potenz einen Wert von mindestens 20, insbesondere einen Wert von größer als 36 auf. Gemäß einem Ausführungsbeispiel weist der Exponent der ersten Potenz einen Wert im Bereich von 20 bis 60, und der Exponent der zweiten Potenz einen Wert im Bereich von 6 bis 10 auf. Die erste Potenz bildet damit zumindest eine Komponente einer Teilgütefunktion mit einem "harten" Zielwert, während die zweite Potenz zumindest eine Komponente einer Teilgütefunktion mit einem "weichen" Zielwert bildet. Die gesamte Gütefunktion gewichtet damit zumindest zwei Zielwerte entsprechend unterschiedlich.

Gemäß einer weiteren Ausführungsform ist die Steuerungsvorrichtung zur Steuerung mehrerer Manipulatoren konfiguriert, die Zustandscharakterisierung umfasst mehrere durch einen Zustandsvektor charakterisierte Zustandsparameter, und jeder der Potenzen umfasst eine Sensitivitätsmatrix, welche einen Zusammenhang zwischen den Stellwegen der Manipulatoren und dem Zustandsvektor definiert. Mit anderen Worten bezeichnet die Sensitivitätsmatrix die Sensitivität der Manipulatoren in Bezug auf deren Bewegungsfreiheitsgrade. Bezogen auf einen Manipulator $M_s$ definiert die Sensitivitätsmatrix, wie sich der Zustandsvektor des Projektionsobjektivs verändert, wenn der Manipulator $M_s$ um einen Standard-Stellweg verstellt wird.

Gemäß einer weiteren Ausführungsform umfasst eine der Potenzen einen Term, welcher einen Bildfehler des Projektionsobjektivs beschreibt. Insbesondere wird dabei der Bildfehler mittels Zernike-Koeffizienten beschrieben.

Gemäß einer weiteren Ausführungsform umfasst eine der Potenzen einen Term, welcher eine Fading-Aberration einer Step- und Scan Projektionsbelichtungsanlage für die Mikrolithographie beschreibt. Bei einer Step-und-Scan-Projektionsbelichtungsanlage bewegen sich während der Abbildung einer Maske auf einen Wafer die Maske und der Wafer relativ zueinander. Unter einer Fading-Aberration ist eine Angabe zu verstehen, wie sich ein Bildfehler in Scanrichtung, d.h. in Richtung der Relativbewegung zwischen Maske und Wafer bei der Belichtung, verändert.

Gemäß einer weiteren Ausführungsform umfasst eine der Potenzen einen Term, welcher einen quadratischen Mittelwert einer Auswahl von Bildfehlern des Projektionsobjektivs beschreibt. Der quadratische Mittelwert wird auch als "RMS-Wert" bezeichnet. Der Exponent der den quadratischen Mittelwert einer Auswahl von Bildfehlern beschreibenden Potenz hat gemäß einer Ausführungsform einen Wert von mindestens 10, insbesondere fällt der Wert in den Bereich von 10 bis 30. Damit bildet diese Potenz zumindest eine Komponente einer Teilgütefunktion mit einem "harten" Zielwert. Die Auswahl an Bildfehlern für den quadratischen Mittelwert umfasst beispielsweise alle Zernike-Koeffizienten Zj mit j $\leq$ 100, insbesondere mit j $\leq$ 64, j $\leq$ 49, j $\leq$ 25 oder j $\leq$ 10. Die Definition der Zernike-Koeffizienten Zj wird nachstehend erläutert.

Gemäß einer weiteren Ausführungsform umfasst eine der Potenzen einen Term, welcher einen reinen Overlay-Fehler beschreibt. Ein Overlay-Fehler gibt eine lokale Bildlageverschiebung einer abgebildeten Maskenstruktur gegenüber deren Solllage auf dem Substrat an.

Gemäß einer weiteren Ausführungsform umfasst eine der Potenzen einen Term, welcher einen mittels mechanischer Nachbearbeitung eines optischen Elements des Projektionsobjektivs korrigierbaren Fehler beschreibt. Derartige Fehler sind beispielsweise bei sogenannten intrinsisch korrigierten Asphären (ICA's) korrigiert. Diese Fehler werden durch nachgelagerte mechanische Bearbeitung einer als optisches Element dienenden Asphäre reduziert bzw. eliminiert.

Gemäß einer weiteren Ausführungsform enthält die Gütefunktion mindestens eine implizite Nebenbedingung für den Stellweg. Eine derartige implizite Nebenbedingung wird im Rahmen der Gütefunktion beschrieben, wie dies beispielsweise bei der auf Seite 45 von WO2010/034674A1 unter ($a^v$) beschriebenen Gütefunktion einer Tikhonov-Regularisierung der Fall ist. Im Gegensatz dazu werden explizite Nebenbedingugen außerhalb der Gütefunktion beschrieben.

Weiterhin wird erfindungsgemäß eine Justieranlage zur Justierung eines Projektionsobjektivs für die Mikrolithographie bereitgestellt. Die Justieranlage umfasst eine Messvorrichtung zur Ermittlung der Zustandscharakterisierung des Projektionsobjektivs, sowie eine Steuerungsvorrichtung in einer der vorstehend beschriebenen Ausführungsformen zur Generierung des Stellwegbefehls aus der Zustandscharakterisierung.

Gemäß einer Ausführungsform der Justieranlage ist die Messvorrichtung als Wellenfrontmesseinrichtung konfiguriert. Eine Wellenfrontmesseinrichtung kann insbesondere als Interferometer, wie etwa als Fizeau-Interferometer, oder als Shack-Hartmann-Sensor konfiguriert sein.

Weiterhin wird erfindungsgemäß eine Projektionsbelichtungsanlage für die Mikrolithographie bereitgestellt. Die Projektionsbelichtungsanlage umfasst ein Projektionsobjektiv zum Abbilden von Maskenstrukturen, mindestens einen Manipulator, welcher dazu konfiguriert ist, eine optische Wirkung mindestens eines optischen Elements des Projektionsobjektivs durch Manipulation einer Eigenschaft des optischen Elements entlang eines Stellweges zu verändern, sowie eine Steuerungsvorrichtung in einer der vorstehend beschriebenen Ausführungformen zur Steuerung des mindestens einen Manipulators.

Die von der Projektionsbelichtungsanlage umfasste Steuerungsvorrichtung kann gemäß einer Ausführungsform eine Simulationseinrichtung umfassen, welche dazu konfiguriert ist, Veränderungen in den optischen Eigenschaften des mindestens einen optischen Elements, die durch Erwärmung des optischen Elements erfolgen, zu simulieren und die Zustandscharakterisierung auf Grundlage des Simulationsergebnisses zu bestimmen. Gemäß einer weiteren Ausführungsform ist die Projektionsbelichtungsanlage zum Betrieb im EUV-Wellenlängenbereich konfiguriert.

Weiterhin wird erfindungsgemäß ein Verfahren zum Steuern mindestens eines Manipulators eines Projektionsobjektivs für die Mikrolithographie bereitgestellt. Das Verfahren umfasst ein Generieren eines Stellwegbefehls für den mindestens einen Manipulator durch Ausführen einer Optimierung einer Gütefunktion. Dabei umfasst die Gütefunktion eine Linearkombination mindestens zweier Potenzen. Eine die Manipulation der Eigenschaft des optischen Elements definierende Einstellung des mindestens einen Manipulators wird mittels einer Stellwegvariablen dargestellt und die jeweilige Basis der mindestens zwei Potenzen enthält eine Funktion der Stellwegvariablen. Weiterhin weisen die Exponenten der mindestens zwei Potenzen unterschiedliche Werte auf. Weiterhin umfasst das Verfahren ein Verändern einer optischen Wirkung mindestens eines optischen Elements des Projektionsobjektivs durch Manipulation einer Eigenschaft des optischen Elements mittels des mindestens einen Manipulators entlang eines durch den generierten Stellwegbefehl definierten Stellweges.

Gemäß einer Ausführungsform erfolgt das Generieren des Stellwegbefehls mittels der Steuerungsvorrichtung in einer der vorstehenden beschriebenen Ausführungsformen.

Kurzbeschreibung der Zeichnungen

Die vorstehenden Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:

Fig. 1 eine Veranschaulichung einer erfindungsgemäßen Ausführungsform einer Steuerungsvorrichtung zur Steuerung von Manipulatoren eines Projektionsobjektivs für die Mikrolithographie sowie einer Nachbearbeitungseinrichtung,

Fig. 2 eine Veranschaulichung einer erfindungsgemäßen Ausführungsform einer Projektionsbelichtungsanlage für die Mikrolithographie mit einem Projektionsobjektiv sowie einer Steuerungsvorrichtung zur Steuerung von Manipulatoren des Projektionsobjektivs, sowie

Fig. 3 ein den Verlauf einer Gütefunktionskomponente veranschaulichendes Diagramm, welche Teil einer Gütefunktion eines in der Steuerungsvorrichtung ablaufenden Optimierungsalgoritmusses ist.

Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden.

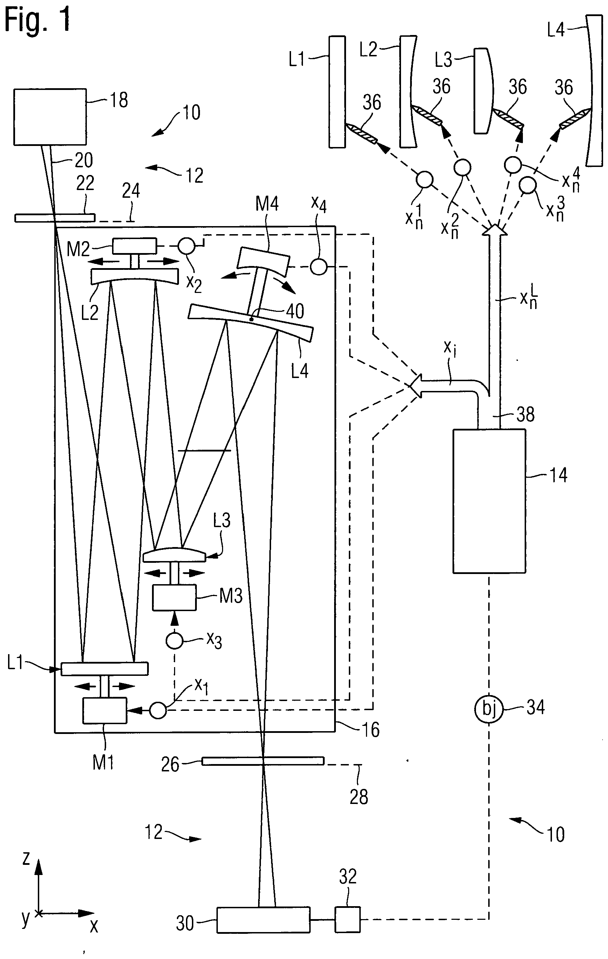

Zur Erleichterung der Beschreibung ist in der Zeichnung ein kartesisches xyz-Koordinatensystem angegeben, aus dem sich die jeweilige Lagebeziehung der in den Figuren dargestellten Komponenten ergibt. In Fig. 1 verläuft die y-Richtung senkrecht zur Zeichenebene in diese hinein, die x-Richtung nach rechts und die z-Richtung nach oben.

Fig. 1 zeigt eine Justieranlage 10 zur Justierung eines Projektionsobjektivs 16 einer Projektionsbelichtungsanlage für die Mikrolithographie. Die Justieranlage 10 umfasst eine Messvorrichtung 12 zur Ermittlung einer Zustandscharakterisierung 34 des Projektionsobjektivs 16 sowie eine Steuerungsvorrichtung 14 in Gestalt eines sogenannten Stellwegsermittlers zur Generierung eines Stellwegbefehls 38 aus der Zustandscharakterisierung 34.

Das Projektionsobjektiv 16 dient zum Abbilden von Maskenstrukturen aus einer Objektebene 24 in eine Bildebene 28 und kann auf Belichtungsstrahlung unterschiedlicher Wellenlängen ausgelegt sein, wie z.B. 248 nm oder 193 nm. In der vorliegenden Ausführungsform ist das Projektionsobjektiv 16 auf eine Wellenlänge im EUV-Wellenlängenbereich, z.B. 13,5 nm, ausgelegt.

Die Messvorrichtung 12 ist zum Vermessen von Wellenfrontfehlern des Projektionsobjektivs 16 konfiguriert und umfasst auf der Eingangsseite des Projektionsobjektivs 16 eine Beleuchtungseinrichtung 18 und eine Messmaske 22 sowie auf der Ausgangsseite des Projektionsobjektivs ein Sensorelement 26, einen Detektor 30 sowie eine Auswerteeinrichtung 32. Die Beleuchtungseinrichtung 18 ist dazu konfiguriert eine Messstrahlung 20 mit der Betriebswellenlänge des zu testenden Projektionsobjektivs 16, im vorliegenden Fall in Gestalt von EUV-Strahlung, zu erzeugen und diese auf die Messmaske 22, welche in der Objektebene 24 angeordnet ist, einzustrahlen. Unter EUV-Strahlung ist im Rahmen dieser Anmeldung elektromagnetische Strahlung einer Wellenlänge kleiner als 100 nm, insbesondere einer Wellenlänge von etwa 13,5 nm oder etwa 6,7 nm zu verstehen. Die Messmaske 22, oft auch "Kohärenzmaske" bezeichnet, weist eine erste periodische Struktur auf. In der Bildebene 28 ist das Sensorelement 26 in Gestalt eines Bildgitters angeordnet, welches eine zweite periodische Struktur aufweist. Auch können Schachbrettstrukturen in der Messmaske 22 mit Schachbrettstrukturen im Sensorelement 26 kombiniert werden. Auch andere dem Fachmann aus dem Gebiet der Scherinterferometrie oder der Punktbeugungsinterferometrie bekannte, Kombinationen von periodischen Strukturen können Verwendung finden.

Unterhalb des Sensorelements 26, und zwar in einer zur Pupillenebene des Projektionsobjektivs 16 konjugierten Ebene, ist ein zweidimensional-auflösender Detektor 30 in Gestalt einer Kamera angeordnet. Das Sensorelement 26 und der Detektor 30 bilden zusammen ein Sensormodul. Die Messmaske 22, und das Sensormodul bilden ein dem Fachmann bekanntes Scherinterferometer oder Punktbeugungsinterferometer und dienen dazu, Wellenfrontfehler des Projektionsobjektivs 16 zu vermessen. Dazu werden insbesondere dem Fachmann bekannte Phasenschiebeverfahren angewendet.

Die Auswerteeinrichtung 32 ermittelt aus den vom Detektor 30 aufgezeichneten Intensitätsmustern die Zustandscharakterisierung 34 des Projektionsobjektivs 16. Gemäß der vorliegenden Ausführungsform umfasst die Zustandscharakterisierung 34 einen die Wellenfrontfehler des Projektionsobjektivs 16 charakterisierenden Satz an Zernikekoeffizienten $b_j$.

In der vorliegenden Anmeldung werden die Zernikefunktionen $Z^n_m$ gemäß der sogenannten Fringe-Sortierung mit $Z_j$ bezeichnet werden, wobei dann $b_j$ die den jeweiligen Zernike-Polynomen (auch "Zernike-Funktionen" bezeichnet) zugeordnete Zernike-Koeffizienten sind. Die Fringe-Sortierung ist beispielsweise in Tabelle 20-2 auf Seite 215 des "Handbook of Optical Systems", Vol. 2 von H. Gross, 2005 Wiley-VCH Verlag GmbH & Co. KGaA, Weinheim veranschaulicht. Eine Wellenfrontabweichung $W(\rho,\Phi)$ an einem Punkt in der Bildebene des Projektionsobjektivs wird in Abhängigkeit von den Polarkoordinaten $(\rho, \Phi)$ in der Pupillenebene wie folgt entwickelt:

$$W(\rho,\Phi) = \sum_j b_j \cdot Z_j(\rho,\Phi) \qquad (1)$$

Während die Zernike-Polynome mit $Z_j$, d.h. mit tiefergestelltem Index j, bezeichnet werden, werden im Rahmen dieser Anmeldung die Zernike-Koeffizienten mit $b_j$ bezeichnet. An dieser Stelle sei angemerkt, dass in der Fachwelt die ZernikeKoeffizienten $b_j$ oft auch mit Zj, d.h. mit normal gestelltem Index, wie beispielsweise Z5 und Z6 für Astigmatismus, bezeichnet werden.

Die von der Auswerteeinrichtung 32 der Messvorrichtung 12 ermittelte Zustandscharakterisierung 34 wird an die Steuerungsvorrichtung 14 übergeben, welche daraus den Stellwegbefehl 38 erzeugt. Der Stellwegbefehl 38 umfasst Stellwege $x_i$ sowie Stellwege $x_n^L$. Diese Stellwege $x_i$ dienen der Steuerung von Manipulatoren $M_s$ des Projektionsobjektivs 16, während die Stellwege $x_n^L$ der Steuerung einer Nachbearbeitungseinrichtung 36 zur mechanischen Nachbearbeitung von optischen Elementen des Projektionsobjektivs 16 dienen. Im Rahmen dieser Anmeldung werden sowohl die Manipulatoren $M_s$ also auch die Nachbearbeitungseinrichtung 36 als Manipulatoren des Projektionsobjektivs 16 im allgemeinen Sinn verstanden.

Das Projektionsobjektiv 16 weist in der Ausführungsform gemäß Fig. 1 lediglich vier optische Elemente L1 bis L4 auf. Alle optischen Elemente sind beweglich gelagert. Dazu ist jedem der optischen Elemente L1 bis L4 ein jeweiliger Manipulator $M_s$, und zwar jeweils einer der Manipulatoren M1 bis M4, zugeordnet. Die Manipulatoren M1, M2 und M3 ermöglichen jeweils eine Verschiebung der zugeordneten optischen Elemente L1, L2 und L3 in x- und in y-Richtung und damit im Wesentlichen parallel zur Ebene, in der die jeweilige reflektierende Oberfläche der optischen Elemente liegt.

Der Manipulator M4 ist dazu konfiguriert, das optische Element L4 durch Drehung um eine parallel zur y-Achse angeordnete Kippachse 40 zu verkippen. Damit wird der Winkel der reflektierenden Oberfläche von L4 gegenüber der einfallenden Strahlung verändert. Weitere Freiheitsgrade für die Manipulatoren sind denkbar. So kann beispielsweise eine Verschiebung eines betreffenden optischen Elements quer zu seiner optischen Oberfläche oder eine Rotation um eine senkrecht zur reflektierenden Oberfläche stehende Referenzachse vorgesehen sein.

Allgemein gesprochen, ist jeder der hier dargestellten Manipulatoren M1 bis M4 dazu vorgesehen, eine Verlagerung des zugeordneten optischen Elements L1 bis L4 unter Ausführung einer Starrkörperbewegung entlang eines vorgegebenen Stellwegs zu bewirkten. Ein derartiger Stellweg kann beispielsweise Translationen in unterschiedlichen Richtungen, Verkippungen und/oder Rotationen in beliebiger Weise kombinieren. Alternativ oder zusätzlich können auch Manipulatoren vorgesehen werden, welche dazu konfiguriert sind, eine anders geartete Veränderung einer Zustandsgröße des zugeordneten optischen Elements durch entsprechende Aktuierung des Manipulators vorzunehmen. Diesbezüglich kann eine Aktuierung beispielsweise durch eine Beaufschlagung des optischen Elements mit einer bestimmten Temperaturverteilung oder einer bestimmten Kräfteverteilung erfolgen. In diesem Fall kann der Stellweg durch eine Veränderung der Temperaturverteilung am optischen Element bzw. das Anlegen einer lokalen Spannung an einem als deformierbare Linse bzw. als deformierbarer Spiegel ausgeführten optischen Elements sein.

Die vom Stellwegbefehl 38 umfassten Stellwege $x_i$ enthalten im gezeigten Fall die Stellwege $x_1$, $x_2$, $x_3$ sowie $x_4$, welche von den Manipulatoren M1 bis M4 auszuführende Veränderungen vorgeben und damit der Steuerung der Manipulatoren M1 bis M4 des Projektionsobjektivs 16 dienen. Die ermittelten Stellwege $x_1$ bis $x_4$ werden den einzelnen Manipulatoren M1 bis M4 über Stellwegsignale übermittelt und geben diesen jeweilige auszuführende Korrekturstellwege vor. Diese definieren entsprechende Verlagerungen der zugeordneten optischen Elemente L1 bis L4 zur Korrektur aufgetretener Wellenfrontfehler des Projektionsobjektivs 16. Für den Fall, in dem ein Manipulator mehrere Freiheitsgrade aufweist, können diesem auch mehrere Stellwege $x_i$ übermittelt werden.

Die weiterhin vom Stellwegbefehl 38 umfassten Stellwege $x_n^L$ enthalten im gezeigten Fall die Stellwege $x_n^1$, $x_n^2$, $x_n^3$ und $x_n^4$, welcher der Steuerung der Nachbearbeitungseinrichtung 36 zur jeweiligen mechanischen Nachbearbeitung der optischen Elementen L1, L2, L3 bzw. L4 des Projektionsobjektivs 16 dienen.

Die Stellwege $x_n^1$ bis $x_n^4$ dienen damit wie die Stellwege $x_1$ bis $x_4$ der Korrektur aufgetretener Wellenfrontfehler des Projektionsobjektivs 16. Unter der Nachbearbeitungseinrichtung 36 ist eine Einrichtung zur mechanischen Abtragung von Material an einer optischen Oberfläche eines optischen Elements in Gestalt einer Linse oder eines Spiegels zu verstehen. Diese Abtragung ist der Herstellung des optischen Elements nachgelagert und dient insbesondere dazu, eine sphärische Oberfläche in eine asphärische Oberfläche zu verändern. Ein entsprechend nachbearbeitetes optisches Element wird daher als intrinsisch korrigierte Asphäre (ICA) bezeichnet. Als Nachbearbeitungseinrichtung 36 kann insbesondere eine üblicherweise zur mechanischen Bearbeitung von ICA's verwendete Abtragungseinrichtung verwendet werden. Die Abtragungen werden nachstehend daher auch als "ICA-Abtragungen" bezeichnet. Zur mechanischen Bearbeitung kann beispielsweise ein Ionenstrahl zum Einsatz kommen. Damit lassen sich beliebige Korrekturprofile in ein nachbearbeitetes optisches Element einarbeiten.

Die Funktionsweise der Steuerungsvorrichtung 14 wird nachstehend exemplarisch veranschaulicht. Diese ist zur Ausführung eines stellwegsgenerierenden Optimierungsalgorithmus konfiguriert. Der Optimierungsalgorithmus dient der Optimierung einer Gütefunktion H, auch Meritfunktion genannt.

Nachstehend werden die Stellwege des vom Optimierungsalgorithmus zu generierenden Stellwegbefehls 38 mit einer Stellwegvariablen beschrieben, welche einen Stellwegvektors $x$ sowie einen weiteren Stellwegvektor $x^L$ umfasst. Die Vektorkomponenten des Stellwegvektors $x$ sind die vorstehend erwähnten einzelnen Stellwege $x_i$ der im Projektionsobjektiv 16 vorgesehenen Manipulatoren. Die Vektorkomponenten des Stellwegvektors $x^L$ sind die der Steuerung der ICA-Nachbearbeitungseinrichtung 36 dienenden Stellwege sowie $x_n^L$. Die Stellwege $x_i$ und $x_n^L$ werden auch als Stellwegvariablen bezeichnet. Die Zustandscharakterisierung 34 wird mit einem Zustandsvektor $b$ beschrieben, dessen Vektorkomponenten die vorstehend erwähnten Zernike-Koeffizienten $b_j$ sind. Die Zernike-Koeffizienten $b_j$ werden auch als Zustandsparameter bezeichnet. Die Sensitivitäten der Manipulatoren, vorliegend der Manipulatoren M1 bis M4, in Bezug auf deren Freiheitsgrade bei einer Zustandsveränderung werden gemäß einer Ausführungsvariante mittels einer Sensitivitätsmatrix $M$ beschrieben. Dabei beschreibt die Sensitivitätsmatrix $M$ den Zusammenhang zwischen einer Verstellung eines Freiheitsgrades $i$ eines Manipulators um einen Standard-Stellweg $x_i^0$ und einer daraus resultierenden Veränderung des Zustandsvektors $b$ des Projektionsobjektivs 16.

Gemäß einer Ausführungsform ist der erfindungsgemäße stellwegsgenerierende Optimierungsalgorithmus zur Lösung des folgenden Optimierungsproblems konfiguriert:

$$\min\ (H) \tag{2}$$

Die Gütefunktion $H$ setzt sich gemäß einer Ausführungsform wie folgt aus mehreren Gütefunktionskomponenten zusammen:

$$H = H_b + H_f + H_{ovl} + H_x + H_{ica} + H_{rms} \tag{3}$$

Hierbei enthält die Komponente $H_b$ gewichtet die einzelnen Zernike-Koeffizienten $b_j$. $H_f$ enthält Spezifikationen bzgl. sogenannter Fading-Aberrationen. Unter einer Fading-Aberration ist eine Angabe zu verstehen, wie sich ein Bildfehler in Scanrichtung einer Projektionsbelichtungsanlage, d.h. in Richtung der Relativbewegung zwischen Maske und Wafer, bei der Belichtung ändert. $H_{ovl}$ enthält Spezifikationen bzgl. sogenannter Overlay-Fehler. Ein Overlay-Fehler gibt eine lokale Bildlageverschiebung einer abgebildeten Maskenstruktur gegenüber deren Solllage auf dem Substrat an. $H_x$ beschreibt die Randbedingungen der Manipulatoren $M_s$. $H_{ica}$ beschreibt Randbedingungen der mittels der Nachbearbeitungseinrichtung 36 vorzunehmenden ICA-Abtragungen. Da die mittels $H_x$ sowie die mittels $H_{ica}$ beschriebenen Randbedingungen im Rahmen der Gütefunktion $H$ beschrieben werden handelt es sich hierbei um sogenannte implizite Nebenbedingungen. $H_{rms}$ enthält gruppierte RMS-Werte der Zernike-Koeffizienten $b_j$. Wie dem Fachmann bekannt ist, ist unter einem RMS-Wert von Koeffizienten die Wurzel aus der Summe der Quadrate der Koeffizienten zu verstehen.

Im Folgenden wird ein Ausführungsbeispiel für die Gütefunktionskomponente $H_b$ beschrieben. Die Bedingung für die einzelnen Zernike-Koeffizienten $b_j$ lautet:

$$\left| (Mx - b)_j \right| \leq S_j^b \tag{4}$$

Hierbei ist $S_j^b$ der Zielwert bzw. die vorgegebene Spezifikation für den Zernike-Koeffizienten $b_j$. $M$ ist die bereits vorstehend beschriebene Sensitivitätsmatrix und $x$ der die Manipulatoren $M_s$ betreffende Stellwegvektor. Die den Beitrag der Zernike-Koeffizienten $b_j$ in der Gütefunktion $H$ beschreibende Gütefunktionskomponente $H_b$ lautet wie folgt:

$$H_b \ = \ \sum_j \left( \frac{(Mx - b)_j}{t_j^b * S_j^b} \right)^{2n_j^b} \tag{5}$$

Hierbei bezeichnen $t_j^b$ und $n_j^b$ vom Benutzer frei wählbare Parameter. Beim jeweiligen Zielwert $S_j^b$ für den entsprechenden Zernike-Koeffizienten handelt es sich gemäß einem Ausführungsbeispiel um einen sogenannten "harten" Zielwert. Dies wird bei der Wahl des jeweiligen Parameters $t_j^b$ berücksichtigt, indem dem Parameter $t_j^b$ ein Wert im Bereich von 0,6 bis 0,95 zugewiesen wird. Der Parameter $t_j^b$ wird auch als Gewichtungsfaktor für den Zielwert $S_j^b$ bezeichnet. Unter einem "harten Zielwert" ist ein Zielwert zu verstehen, der nur geringfügig über- bzw. unterschritten werden darf.

Nimmt man die Ersetzungen $\delta b_j = (Mx - b)_j$ sowie $sb_j = t_j^b * S_j^b$ vor, so läßt sich $H_b$ wie folgt ausdrüken:

$$H_b = \sum_j \left(\frac{\delta b_j}{sb_j}\right)^{2n_j^b} \tag{5'}$$

$H_b$ ist damit eine Linearkombination der Potenzen $\left(\frac{\delta b_j}{sb_j}\right)^{2n_j^b}$. Die Basis $\left(\frac{\delta b_j}{sb_j}\right)$ der Potenzen enthält eine Funktion des Stellwegvektors x und damit der Stellwegvariablen $x_i$. Die vorstehend erwähnten frei wählbaren Parameter $n_j^b$ sind die zugehörigen Exponenten der vorgenannten Potenzen. Da es sich im vorliegenden Ausführungsbeispiel beim Zielwert $S_j^b$ um einen "harten" Zielwert handelt, wird dem jeweiligen Exponenten $n_j^b$ ein Wert von größer als 10, insbesondere von größer als 18 zugewiesen. Gemäß einem Ausführungsbeispiel befindet sich der dem jeweiligen Exponenten $n_j^b$ zugewiesene Wert jeweils im Bereich von 10 bis 30.

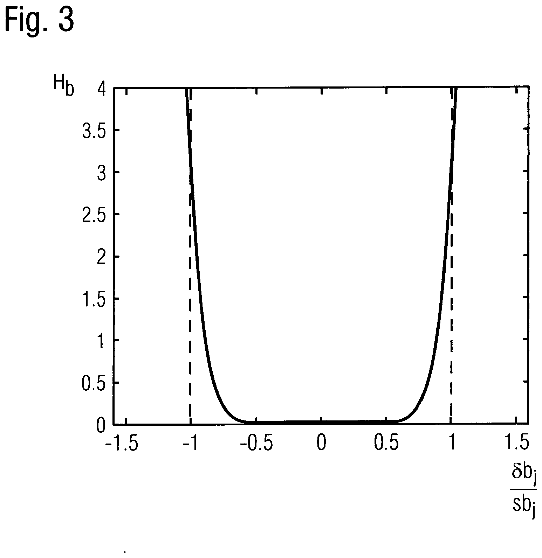

Das in Fig. 3 dargestellte Diagramm zeigt die Gütefunktionskomponente $H_b$ als Funktion der Basis $\left(\frac{\delta b_j}{sb_j}\right)$. Wie sich aus dem Diagramm ablesen lässt, wird die

Funktion aufgrund der Wahl des Exponenten $n_j^b$ sehr steil, wenn sich $\delta b_j$ betragsmäßig nahe am gewichteten Zielwert $sb_j$ befindet. Ausreißer bei Zernike-Koeffizienten $b_j$, d.h. Werte von $b_j$ oberhalb bzw. unterhalb des Zielwerts, werden damit zwar zugelassen, aber so stark gewichtet, dass sie praktisch kaum vorkommen.

Im Folgenden wird ein Ausführungsbeispiel für die Gütefunktionskomponente $H_f$ beschrieben. Die sogenannten Fading-Aberrationen $b_f^j$ können aus den gemessenen Zernike-Aberrationen $b_j$ berechnet werden. Die Bedingung für die Fading-Aberrationen $b_f^j$ lautet wie folgt:

$$\delta f_j \le S_j^f \tag{6}$$

wobei

$$\delta f_j \;=\; \sqrt{\sum_m w_m \left(M_f^j x - b_f^j\right)^2_m}$$

(7)

Hierbei ist $S_j^f$ der Zielwert bzw. die vorgegebene Spezifikation für die Fading-Aberration $b_f^j$. Die Summe m geht über alle Feldpunkte entlang der ScanRichtung der Projektionsbelichtungsanlage. Der Parameter $w_m$ bezeichnet sogenannte Scan-Gewichte, d.h. Gewichtungen der Bildfehler, die auf die Scanbewegung zurückgehen. $M_f^j$ bezeichnet eine Sensitivitätsmatrix für die Fading-Aberrationen $b_f^j$ und definiert damit die Veränderung des Zustandsvektors b des Projektionsobjektivs aufgrund von Fading-Aberrationen bei Verstellung der Manipulatoren $M_s$ um einen Standardverstellweg $x_0$.

Die den Beitrag der Fading-Aberrationen in der Gütefunktion H beschreibende Gütefunktionskomponente $H_f$ lautet wie folgt:

$$H_f = \sum_j \left(\frac{\delta f_j}{t_j^f S_j^f}\right)^{2n_j^f}$$

(8)

Hierbei bezeichnen $t_j^f$ und $n_j^f$ vom Benutzer frei wählbare Parameter. Beim jeweiligen Zielwert $S_j^f$ für die entsprechende die Fading-Aberration handelt es sich gemäß einem Ausführungsbeispiel um einen sogenannten "harten" Zielwert. Dies wird bei der Wahl des jeweiligen Parameters $t_j^f$ berücksichtigt, indem dem Parameter $t_j^f$ ein Wert im Bereich von 0,6 bis 0,95 zugewiesen wird. Der Parameter $t_j^f$ wird auch als Gewichtungsfaktor für den Zielwert $S_j^f$ bezeichnet. $H_f$ ist damit eine Linearkombination der Potenzen $\left(\frac{\delta f_j}{t_j^f S_j^f}\right)^{2n_j^f}$. Die Basis $\left(\frac{\delta f_j}{t_j^f S_j^f}\right)$ der Potenzen enthält eine Funktion des Stellwegvektors x und damit der Stellwegvariablen $x_i$. Die vorstehend erwähnten frei wählbaren Parameter $n_j^f$ sind die zugehörigen Exponenten der vorgenannten Potenzen. Da es sich im vorliegenden Ausführungsbeispiel beim Zielwert $S_j^f$ um einen "harten" Zielwert handelt, wird dem jeweiligen Exponenten $n_j^f$ ein Wert von größer als 10, insbesondere von größer als 18 zugewiesen. Gemäß einem Ausführungsbeispiel befindet sich der dem jeweiligen Exponenten $n_j^f$ zugewiesene Wert jeweils im Bereich von 10 bis 30.

Der Verlauf der Gütefunktionskomponente $H_f$ in Abhängigkeit der Basis $\left( \dfrac{\delta f_j}{t_j^f S_j^f} \right)$ entspricht im Wesentlichen dem in Fig. 3 dargestellten Verlauf der Gütefunktionskomponente $H_b$. Die vorstehend bezüglich des Verlaufs des Diagramms gemäß Fig. 3 gemachten Erläuterungen lassen sich daher auf den Verlauf von $H_f$ übertragen.

Im Folgenden wird ein Ausführungsbeispiel für die Gütefunktionskomponente $H_{ovl}$ beschrieben. Overlay-Fehler werden für unterschiedliche Strukturtypen, wie beispielsweise isolierte Linien, als Gitter angeordnete Linien, kreisförmige Strukturen etc, bestimmt. Die unterschiedlichen Strukturtypen werden mit der Zählvariablen p bezeichnet. Ein Overlay-Fehler in Abhängigkeit vom Strukturtyp p sowie vom Feldpunkt m wird mit dem Produkt $(SZ^pb)_m$ beschrieben. $SZ^p$ ist dabei eine Matrix, welche feldpunktabhängige Gewichte für die einzelnen Zernike-Koeffizienten $b_j$ umfasst. Ein Overlay-Fehler $(SZ^pb)_m$ wird damit durch Linearkombinationen einzelner Zernike-Koeffizienten $b_j$ gebildet.

Die Bedingung für die Overlay-Fehler $(SZ^pb)_m$ im Optimierungsalgorithmus lautet wie folgt:

$$\text{OVL}_p \leq S_p^{ovl} \qquad , \qquad (9)$$

wobei

$$\text{OVL}_p = \max_m \left( (SZ^P M x - SZ^P b)_m \right) \qquad (10)$$

Hierbei ist $S_p^{ovl}$ der Zielwert bzw. die vorgegebene Spezifikation für den Overlay-Fehler des Strukturtyps p. Die Matrix M ist die bereits vorstehend in Bezug auf die Gütefunktionskomponente $H_b$ beschriebene Sensitivitätsmatrix. Die max-Funktion bestimmt das Maximum über alle Feldpunkte m.

Die den Beitrag der Overlay-Fehler in der Gütefunktion H beschreibende Gütefunktionskomponente $H_{ovl}$ lautet wie folgt:

$$H_{ovl} = \sum_m \sum_p \left( \frac{(SZ^P M x - SZ^P b)_m}{t_p^{ovl} * S_p^{ovl}} \right)^{2n_p^{ovl}} \qquad (11)$$

Hierbei bezeichnen $t_p^{ovl}$ und $n_p^{ovl}$ vom Benutzer frei wählbare Parameter. Beim Zielwert jeweiligen $S_p^{ovl}$ für den entsprechenden Overlay-Fehler handelt es sich gemäß einem Ausführungsbeispiel um einen sogenannten "harten" Zielwert. Dies wird bei der Wahl des jeweiligen Parameters $t_p^{ovl}$ berücksichtigt, indem dem Parameter $t_p^{ovl}$ ein Wert im Bereich von 0,6 bis 0,95 zugewiesen wird. Der Parameter $t_p^{ovl}$ wird auch als Gewichtungsfaktor für den Zielwert $S_p^{ovl}$ bezeichnet.

$H_{ovl}$ ist damit eine Linearkombination der Potenzen $\left( \dfrac{(SZ^P M x - SZ^P b)_m}{t_p^{ovl} * S_p^{ovl}} \right)^{2n_p^{ovl}}$ . Die Basis

$$\left( \frac{(SZ^P M x - SZ^P b)_m}{t_p^{ovl} * S_p^{ovl}} \right)$$

der Potenzen enthält eine Funktion des Stellwegvektors x und damit der Stellwegvariablen $x_i$. Die vorstehend erwähnten frei wählbaren Parameter $n_p^{ovl}$ sind die zugehörigen Exponenten der vorgenannten Potenzen. Da es sich im vorliegenden Ausführungsbeispiel beim Zielwert $S_p^{ovl}$ um einen "harten" Zielwert handelt, wird dem jeweiligen Exponenten $n_p^{ovl}$ ein Wert von größer als 10, insbesondere von größer als 18 zugewiesen. Gemäß einem Ausführungsbeispiel befindet sich der dem jeweiligen Exponenten $n_p^{ovl}$ zugewiesene Wert jeweils im Bereich von 10 bis 30.

Der Verlauf der Gütefunktionskomponente $H_{ovl}$ in Abhängigkeit der Basis

$$\left( \frac{(SZ^P M x - SZ^P b)_m}{t_p^{ovl} * S_p^{ovl}} \right)$$

entspricht im Wesentlichen dem in Fig. 3 dargestellten Verlauf der Gütefunktionskomponente $H_b$. Die vorstehend bezüglich des Verlaufs des Diagramms gemäß Fig. 3 gemachten Erläuterungen lassen sich daher auf den Verlauf von $H_{ovl}$ übertragen.

Im Folgenden wird ein Ausführungsbeispiel für die Gütefunktionskomponente $H_x$ beschrieben. Die Stellwege $x_i$ der Manipulatoren $M_s$ weisen untere Grenzwerte $x_i^{min}$ und obere Grenzwerte $x_i^{max}$ auf, so dass gilt:

$$x_i^{min} \leq x_i \leq x_i^{max} \tag{12}$$

Wie bereits vorstehend erläutert, bezeichnet ein einzelnes $x_i$ einen Freiheitsgrad eines Manipulators $M_s$, wobei die einzelnen Manipulatoren einen oder mehrere Freiheitsgrade aufweisen können. Verwendet man die folgenden Ersetzungen:

$$y_i = (m_i x_i + c_i) \tag{13}$$

$$m_i = \frac{2}{x_i^{max} - x_i^{min}} \tag{14}$$

$$c_i = \frac{x_i^{max} + x_i^{min}}{x_i^{min} - x_i^{max}} \quad , \tag{15}$$

so lässt sich Gleichung (12) in der folgenden Form ausdrücken:

$$-1 \leq y_i \leq 1 \tag{16}$$

Die die Grenzwerte der Manipulatoren betreffende Gütefunktionskomponente $H_x$ lautet dann:

$$H_x = \sum_{i=1}^{DOF} \left( \frac{y_i}{t_i^y} \right)^{2n_i^y} \qquad (17)$$

Hierbei geht die Summe der Zählvariablen i über alle Freiheitsgrade aller Manipulatoren $M_s$. Die vom Nutzer frei wählbaren Parameter sind $t_i^y$ und $n_i^y$. Bei den Grenzwerten $x_i^{min}$ und $x_i^{max}$ handelt es sich um sogenannte "harte" Zielwerte. Dies wird bei der Wahl des entsprechenden Parameters $t_i^y$ berücksichtigt, indem dem Parameter $t_i^y$ ein Wert im Bereich von 0,6 bis 0,95 zugewiesen wird.

$H_x$ ist damit eine Linearkombination der Potenzen $\left( \frac{y_i}{t_i^y} \right)^{2n_i^y}$. Der Parameter $y_i$ und damit die Basis $\left( \frac{y_i}{t_i^y} \right)$ der Potenzen enthält eine Funktion des Stellwegvektors x und damit der Stellwegvariablen $x_i$. Die vorstehend erwähnten frei wählbaren Parameter $n_i^y$ sind die zugehörigen Exponenten der vorgenannten Potenzen. Da es sich im vorliegenden Ausführungsbeispiel bei den Grenzwerten $x_i^{min}$ und $x_i^{max}$ um "harte" Zielwerte handelt, wird dem jeweiligen Exponenten $n_i^y$ ein Wert von größer als 10, insbesondere von größer als 18 zugewiesen. Gemäß einem Ausführungsbeispiel liegt der dem jeweiligen Exponenten $n_i^y$ zugewiesene Wert jeweils im Bereich von 10 bis 30.

$$\left( \frac{y_i}{t_i^y} \right)$$

Der Verlauf der Gütefunktionskomponente $H_x$ in Abhängigkeit der Basis entspricht im Wesentlichen dem in Fig. 3 dargestellten Verlauf der Gütefunktionskomponente $H_b$. Die vorstehend bezüglich des Verlaufs des Diagramms gemäß Fig. 3 gemachten Erläuterungen lassen sich daher auf den Verlauf von $H_x$ übertragen.

Im Folgenden wird ein Ausführungsbeispiel für die Gütefunktionskomponente $H_{ica}$ beschrieben. Wie bereits vorstehend erwähnt, beschreibt $H_{ica}$ Randbedingungen der mittels der Nachbearbeitungseinrichtung 36 an einzelnen optischen Elementen, wie den optischen Elementen L1 bis L4 des Projektionsobjektivs 16 gemäß Fig. 1, vorzunehmenden ICA-Abtragungen. Die mittels ICA-Abtragungen in einem optischen Element erzeugten Profile $F_L(x^K, y^K)$ können wie folgt als Summe von n Basisfunktionen $f_n^L(x^K, y^K)$ beschrieben werden:

$$F_L(x^K, y^K) = \sum_o f_o^L(x^K, y^K) x_n^L \qquad (18)$$

Hierbei bezeichnen $x^K$ und $y^K$ die kartesischen x- und y-Koordinaten auf einem betreffenden optischen Element L. Die Basisfunktionen $f_o^L(x^K, y^K)$ werden gemäß einem Ausführungsbeispiel aus den gemessenen Zernike-Koeffizienten $b_j$ des Projektionsobjektivs 16 unter Verwendung einer die Sensitivitäten für ICA-Abtragungen enthaltenden Umrechnungsmatrix berechnet. In diesem Fall enthalten die Basisfunktionen $f_o^L(x^K, y^K)$ eine Summe von Zernikepolynomen. Alternativ können die Basisfunktionen $f_o^L(x^K, y^K)$ auch aus Spline-Funktionen, Legendre-Polynomen, etc. aufgebaut sein.

Eine Peak-to-Valley Funktion $PV_L$ der ICA-Abtragungen wird wie folgt definiert

$$PV_L = \max_{x^K, y^K} F_L(x^K, y^K) - \min_{x^K, y^K} F_L(x^K, y^K) \qquad (19)$$

Die Grenzwertbedingung für das resultierende Profil $F_L(x^K, y^K)$ lautet:

$$PV_L \le S_L^{pv} \qquad (20)$$

Hierbei ist der Zielwert $S_L^{pv}$ ein Wert, welcher durch den Ionenstrahlherstellungsprozess bestimmt wird. Gleichung (20) stellt sicher, dass Variationen des Profils nicht beliebig groß werden können. Beim entsprechenden Zielwert $S_L^{pv}$ handelt es sich gemäß dem beschriebenen Ausführungsbeispiel um einen sogenannten "weichen" Zielwert, der nicht so exakt einzuhalten ist wie ein "harter" Zielwert.

Die die Grenzwerte von ICA-Abtragungen betreffende Gütefunktionskomponente $H_{ica}$ lautet wie folgt:

$$H_{ica} = \sum_L \sum_n \left( \frac{2 f_n^L(x^K, y^K) x_n^L}{t_L^{pv} * S_L^{pv}} \right)^{2 n_L^{pv}} \qquad (21)$$

Die Summe über den Index L geht über alle optische Elemente, bei denen ICA-Abtragungen vorgenommen werden und die Summe über k geht über alle zur Beschreibung des betreffenden optischen Elements verwendeten Basisfunktonen. Weiterhin bezeichnen $t_L^{pv}$ und $n_L^{pv}$ vom Benutzer frei wählbare Parameter. Da es sich beim Zielwert $S_L^{pv}$ für das entsprechende Profil der ICA-Abtragung um einen "weichen" Zielwert handelt, wird dem Parameter $t_L^{pv}$ ein Wert im Bereich von 0,5 bis 2,0 zugewiesen. Der Parameter $t_L^{pv}$ wird auch als Gewichtungsfaktor für den Zielwert $S_L^{pv}$ bezeichnet.

$H_{ica}$ ist damit eine Linearkombination der Potenzen $\left( \frac{2 f_n^L(x^K, y^K) x_n^L}{t_L^{pv} * S_L^{pv}} \right)^{2 n_L^{pv}}$ . Die Basis $\left( \frac{2 f_n^L(x^K, y^K) x_n^L}{t_L^{pv} * S_L^{pv}} \right)$ der Potenzen enthält eine Funktion des vorstehend beschriebenen Stellwegvektors $x^L$ und damit der Stellwegvariablen $x_n^L$ . Die vorstehend erwähnten frei wählbaren Parameter $n_L^{pv}$ sind die zugehörigen Exponenten der vorgenannten Potenzen. Da es sich im vorliegenden Ausführungsbeispiel beim Zielwert $S_L^{pv}$ um einen "weichen" Zielwert handelt, wird dem Exponenten $n_L^{pv}$ ein Wert von 3 bis 10 zugewiesen.

Der Verlauf der Gütefunktionskomponente $H_{ica}$ in Abhängigkeit der Basis $\left(\dfrac{2 f_n^L(x^K, y^K) x_n^L}{t_L^{pv} * S_L^{pv}}\right)$ unterscheidet sich von dem in Fig. 3 dargestellten Verlauf der Gütefunktionskomponente $H_b$ im Wesentlichen darin, dass die Annäherung an die bei -1 und +1 angeordneten vertikalen Linien weniger steil erfolgt und die Linien stärker überschritten werden.

Im Folgenden wird ein Ausführungsbeispiel für die Gütefunktionskomponente $H_{rms}$ beschrieben. Dazu werden gruppierte RMS-Werte $RMS^r$ wie folgt definiert:

$$RMS^r = \max_m \sqrt{\sum_j \left(\alpha_j^r (Mx - b)_{j,m}^2\right)} \tag{22}$$

Hierbei ist r eine Zählvariable des gruppierten RMS-Werts $RMS^r$. Die Gruppierung erfolgt beispielsweise durch Einordung der entsprechenden Zernike-Koeffizienten $b_j$ in die Kategorien "sphärische Aberrationen", "Koma", "Astigmatismus", etc. Die Summe über j ist eine Summe über die Zernike-Ordnungen, $\alpha_j^r$ sind die Gewichte der individuellen Zernike-Beiträge $b_j$ zum RMS-Wert mit dem Index r und das Maximum wird über alle Feldpunkte m des Bildfeldes des Projektionsobjektivs 16 ermittelt. Die gruppierten RMS-Werte $RMS^r$ umfassen gemäß unterschiedlichen Ausführungsformen alle Zernike-Koeffizienten Zj mit j ≤ 10, mit j ≤ 25, mit j ≤ 49, mit j ≤ 64 oder mit j ≤ 100.

Die Bedingungen für die RMS-Werte lauten:

$$RMS^r \le S_r^{rms} \tag{23}$$

Hierbei ist $S_r^{rms}$ der Zielwert bzw. die vorgegebene Spezifikation für den RMS-Wert mit dem Index r. Die den Beitrag der RMS-Werte in der Gütefunktion H beschreibende Gütefunktionskomponente $H_{rms}$ lautet wie folgt:

$$H_{rms} = \sum_r \sum_m \left(\sum_j \frac{\alpha_r^j (Mx - b)_{j,m}^2}{(t_r^{rms} S_r^{rms})^2}\right)^{n_r^{rms}} \tag{24}$$

Hierbei bezeichnen $t_r^{rms}$ und $n_r^{rms}$ vom Benutzer frei wählbare Parameter. Beim jeweiligen Zielwert $S_r^{rms}$ für den entsprechenden RMS-Wert handelt es sich gemäß einem Ausführungsbeispiel um einen sogenannten "harten" Zielwert. Dies wird bei der Wahl des jeweiligen Parameters $t_r^{rms}$ berücksichtigt, indem dem Parameter $t_r^{rms}$ ein Wert im Bereich von 0,6 bis 0,95 zugewiesen wird. Der Parameter $t_r^{rms}$ wird auch als Gewichtungsfaktor für den Zielwert $S_r^{rms}$ bezeichnet. $H_{rms}$ ist damit eine Linearkombination der Potenzen

$$\left(\sum_j \frac{\alpha_r^j (Mx - b)_{j,m}^2}{(t_r^{rms} S_r^{rms})^2}\right)^{n_r^{rms}} \qquad \left(\sum_j \frac{\alpha_r^j (Mx - b)_{j,m}^2}{(t_r^{rms} S_r^{rms})^2}\right)$$

Die Basis der Potenzen enthält eine Funktion des Stellwegvektors x und damit der Stellwegvariablen $x_i$. Die vorstehend erwähnten frei wählbaren Parameter $n_r^{rms}$ sind die zugehörigen Exponenten der vorgenannten Potenzen. Da es sich im vorliegenden Ausführungsbeispiel beim Zielwert $S_r^{rms}$ um einen "harten" Zielwert handelt, wird dem jeweiligen Exponenten $n_r^{rms}$ ein Wert von größer als 20, insbesondere von größer als 36 zugewiesen. Gemäß einem Ausführungsbeispiel befindet sich der dem Exponenten $n_r^{rms}$ zugewiesene Wert im Bereich von 20 bis 60.

$$\left( \sum_j \frac{\alpha_r^j \, (Mx - b)_{j,m}^2}{(t_r^{rms} S_r^{rms})^2} \right)$$

Der Verlauf der Gütefunktionskomponente $H_{rms}$ in Abhängigkeit der Basis entspricht im Wesentlichen dem in Fig. 3 dargestellten Verlauf der Gütefunktionskomponente $H_b$. Die vorstehend bezüglich des Verlaufs des Diagramms gemäß Fig. 3 gemachten Erläuterungen lassen sich daher auf den Verlauf von $H_{rms}$ übertragen.

Die Parameter $n_j^b$, $n_j^f$, $n_p^{ovl}$, $n_i^y$, $n_L^{pv}$ und $n_r^{rms}$ werden so gewählt, dass die sich dabei in den einzelnen Gütefunktionskomponenten ergebenden Exponenten $2n_j^b$, $2n_j^f$, $2n_p^{ovl}$, $2n_i^y$, $2n_L^{pv}$ und $n_r^{rms}$ mindestens zwei unterschiedliche Werte aufweisen. Mit anderen Worten gibt es zumindest einen Exponenten, dessen Wert von denjenigen der anderen Exponenten abweicht. Gemäß weiterer Ausführungsbeispiele weisen die vorgenannten Exponenten eine Vielzahl unterschiedlicher Werte auf, insbesondere weist jeder der Exponenten einen anderen Wert auf. Damit können die Gewichtungen der unterschiedlichen Optimierungsgrößen bei der Optimierung gezielt individuell eingestellt werden, und damit das Optimierungsergebnis optimal an die vorliegenden Randbedingungen angepasst werden.

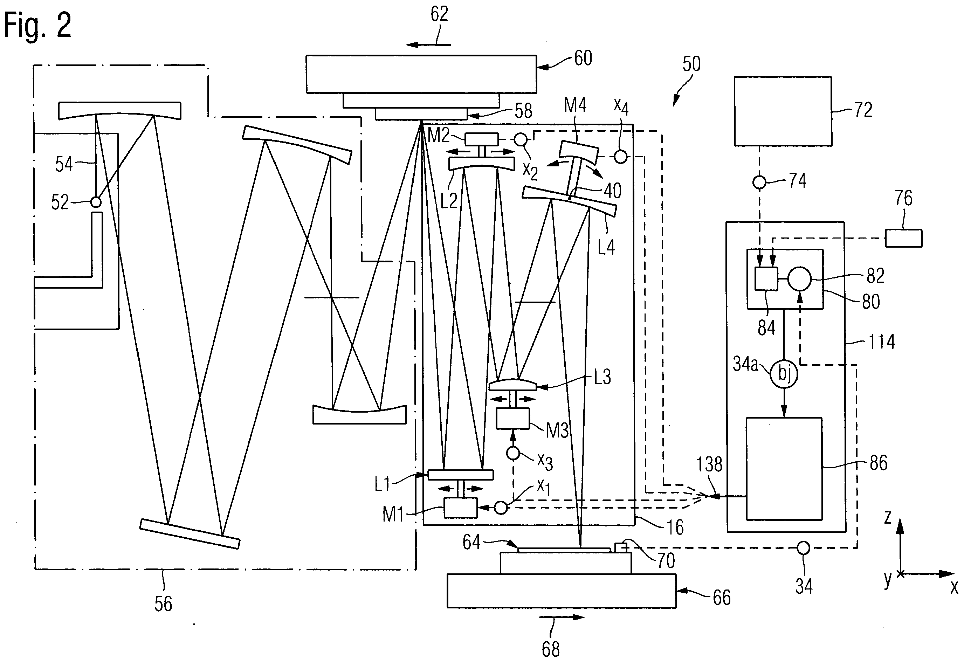

Fig. 2 zeigt eine erfindungsgemäße Ausführungsform einer Projektionsbelichtungsanlage 50 für die Mikrolithographie. Die vorliegende Ausführungsform ist zum Betrieb im EUV-Wellenlängenbereich ausgelegt. Aufgrund dieser Betriebswellenlänge sind alle optischen Elemente als Spiegel ausgeführt. Die Erfindung ist jedoch nicht auf Projektionsbelichtungsanlagen im EUV-Wellenlängenbereich begrenzt. Weitere erfindungsgemäße Ausführungsformen sind beispielsweise auf Betriebswellenlängen im UV-Bereich, wie beispielsweise 365 nm, 248 nm oder 193 nm ausgelegt. In diesem Fall sind zumindest einige der optischen Elemente als herkömmliche Transmissionslinsen konfiguriert.

Die Projektionsbelichtungsanlage 10 gemäß Fig. 2 umfasst eine Belichtungsstrahlungsquelle 52 zur Erzeugung von Belichtungsstrahlung 54. Im vorliegenden Fall ist die Belichtungsstrahlungsquelle 52 als EUV-Quelle ausgeführt und kann beispielsweise eine Plasmastrahlungsquelle umfassen. Die Belichtungsstrahlung 54 durchläuft zunächst eine Beleuchtungsoptik 56 und wird von dieser auf eine Maske 58 gelenkt. Die Beleuchtungsoptik 56 ist dazu konfiguriert, unterschiedliche Winkelverteilungen der auf die Maske 58 auftreffenden Belichtungsstrahlung 54 zu erzeugen. Abhängig von einer vom Benutzer gewünschten Beleuchtungseinstellung, auch "Beleuchtungssetting" genannt, konfiguriert die Beleuchtungsoptik 56 die Winkelverteilung der auf die Maske 58 auftreffenden Belichtungsstrahlung 54. Beispiele für wählbare Beleuchtungseinstellungen umfassen eine sogenannte Dipol-Beleuchtung, annulare Beleuchtung und Quadrupolbeleuchtung.

Die Maske 58 weist Maskenstrukturen zur Abbildung auf ein Substrat 64 in Gestalt eines Wafers auf und ist auf einer Maskenverschiebebühne 60 verschiebbar gelagert. Die Maske 58 kann, wie in Fig. 2 dargestellt, als Reflexionsmaske ausgeführt sein oder alternativ, insbesondere für die UV-Lithographie, auch als Transmissionsmaske konfiguriert sein. Die Belichtungsstrahlung 54 wird in der Ausführungsform gemäß Fig. 2 an der Maske 58 reflektiert und durchläuft daraufhin das bereits unter Bezugnahme auf die Justieranlage 10 gemäß Fig. 1 beschriebene Projektionsobjektiv 16. Das Projektionsobjektiv dient dazu, die Maskenstrukturen der Maske 58 auf das Substrat 64 abzubilden. Die Belichtungsstrahlung 54 wird innerhalb des Projektionsobjektivs 16 mittels einer Vielzahl von optischen Elementen, vorliegend in Gestalt von Spiegeln, geführt. Das Substrat 64 ist auf einer Substratverschiebebühne 66 verschiebbar gelagert. Die Projektionsbelichtungsanlage 50 kann als sogenannter Scanner oder als sogenannter Stepper ausgeführt sein.

Im Fall der Ausführung als Scanner, auch Step- und Scan-Projektionsbelichtungsanlage genannt, werden bei jeder Abbildung der Maske 58 auf das Substrat 64, d.h. bei jeder Belichtung eines Feldes auf dem Substrat 64, die Maskenverschiebebühne 60 sowie die Substratverschiebebühne 66 in gegenläufiger Richtung bewegt. Wie in Fig. 2 gezeigt, bewegt sich dabei beispielsweise die Maskenverschiebebühne 60 in eine nach links weisende Scanrichtung 62 und die Substratverschiebebühne in eine nach rechts weisende Scanrichtung 68. Die vorstehend im Zusammenhang mit der Beschreibung der Gütefunktionskomponente $H_f$ erläuterten Fading-Aberrationen sind auf die Scanbewegungen während der Feldbelichtung eines derartigen Scanners zurückzuführen.

Die Projektionsbelichtungsanlage 50 umfasst weiterhin eine zentrale Steuerungseinrichtung 72 zur Steuerung des Belichtungsvorganges, einschließlich der Maskenverschiebebühne 60 sowie der Substratverschiebebühne 66. Die Projektionsbelichtungsanlage 10 umfasst weiterhin eine Steuerungsvorrichtung 114 zur Steuerung der Manipulatoren M1 bis M4. Die Steuerungsvorrichtung 114 wiederum umfasst einen Zustandsgeber 80 sowie einen Stellwegsermittler 86.

Der Zustandsgeber 80 übergibt aktuelle Zustandscharakterisierungen 34a des Projektionsobjektivs 16 an den Stellwegsermittler 86, welcher daraus einen Stellwegbefehl 138 erzeugt. Der Stellwegbefehl 138 umfasst Stellwege $x_i$, im gezeigten Fall die Stellwege $x_1$, $x_2$, $x_3$ sowie $x_4$. Diese Stellwege dienen der Steuerung der Manipulatoren M1 bis M4, wie vorstehend in Bezug auf die Justieranlage 10 gemäß Fig. 1 näher beschrieben.

Der vom Stellwegsermittler 86 erzeugte Stellwegbefehl 138 umfasst von den Manipulatoren M1 bis M4 auszuführende Veränderungen in Form von Stellwegen $x_i$ entsprechender Zustandsgrößen der optischen Elemente L1 bis L4. Die ermittelten Stellwege $x_i$ werden den einzelnen Manipulatoren M1 bis M4 über Stellwegsignale übermittelt und geben diesen jeweilige auszuführende Korrekturstellwege vor. Diese definieren entsprechende Verlagerungen der zugeordneten optischen Elemente L1 bis L4 zur Korrektur aufgetretener Wellenfrontfehler des Projektionsobjektivs 16. Zur Ermittlung der Stellwege $x_i$ erhält der Stellwegsermittler 86 von Zustandsgeber 80, insbesondere während der Ausführung des Belichtungsvorganges, jeweils aktualisierte Zustandscharakterisierungen 34a in Gestalt von die Wellenfront charakterisierenden Zernike-Koeffizienten $b_j$.

Der Stellwegsermittler 86 erzeugt gemäß einer Ausführungsform während der Belichtung eines Substrats 64 mehrfach aktualisierte Stellwege $x_i$. Gemäß einer Ausführungsform weist der Zustandsgeber 80 einen Speicher 82 sowie eine Simulationseinrichtung 84 auf. Im Speicher 82 werden Zustandscharakterisierungen 34 in Gestalt von Aberrationsparametern abgespeichert, die mittels einer Wellenfrontmessung an dem Projektionsobjektiv 16 ermittelt worden sind. Diese Messergebnisse können mittels einer externen Wellenfrontmessvorrichtung, wie der in Bezug auf Fig. 1 beschriebenen Messvorrichtung 12, erhoben werden. Alternativ können die Zustandscharakterisierungen 34 aber auch von einer in der Substratverschiebebühne 66 integrierten Wellenfrontmesseinrichtung 70 gemessen werden. Eine derartige Messung kann etwa regelmäßig nach jeder Belichtung eines Wafers oder jeweils nach Belichtung eines kompletten Wafersatzes erfolgen. Alternativ kann anstatt einer Messung auch eine Simulation bzw. eine Kombination aus Simulation und reduzierter Messung vorgenommen werden.

Die im Speicher 82 abgelegten Messwerte der Zustandscharakterisierung 34 in Gestalt von Aberrationsparametern in Form von Zernike-Koeffizienten werden ggf. von der Simulationseinrichtung 84 an jeweilige aktualisierte Verhältnisse während des Belichtungsvorganges angepasst. Gemäß einer Ausführungsvariante wird der Simulationseinrichtung 84 dazu regelmäßig von der zentralen Steuerungseinrichtung 72 die aktuelle Bestrahlungsintensität 74 übermittelt. Die Simulationseinrichtung 84 berechnet daraus unter Zugrundelegung der jeweiligen Beleuchtungseinstellung aufgrund von Linsenaufheizung bewirkte Änderungen in den Aberrationsparametern. Weiterhin erhält die Simulationseinrichtung laufend Messwerte eines den Umgebungsdruck der Projektionsbelichtungsanlage 10 überwachenden Drucksensors 76. Auswirkungen von Veränderungen im Umgebungsdruck auf die Aberrationsparameter werden von der Simulationseinrichtung 84 berücksichtigt.

Die Steuerungsvorrichtung 114 der Projektionsbelichtungsanlage 50 gemäß Fig. 2 unterscheidet sich von der Steuerungseinrichtung 14 der Justieranlage 10 gemäß Fig. 1 dadurch, dass die Steuerungsvorrichtung 114 mittels des Zustandsgebers 80 die von einer Wellenfrontmesseinrichtung gemessene Zustandscharakterisierung 34 unter Verwendung der aktuellen Beleuchtungsintensität 74 in eine aktuelle Zustandscharakterisierung 34a umwandelt. Die Funktion des Stellwegsermittlers 86 der Steuerungsvorrichtung 114 entspricht der Funktion der Steuerungseinrichtung 14, allerdings mit der Einschränkung, dass der von der Steuerungsvorrichtung 114 erzeugte Stellwegsbefehl 138 lediglich den Stellwegvektor x mit den Stellwegen $x_i$ der Manipulatoren, nicht jedoch den Stellwegvektor $x^L$ zur Steuerung der ICA-Nachbearbeitungseinrichtung 36 umfasst.

Die vorstehende Beschreibung beispielhafter Ausführungsformen ist exemplarisch zu verstehen. Die damit erfolgte Offenbarung ermöglicht es dem Fachmann, die vorliegende Erfindung und die damit verbundenen Vorteile zu verstehen.

**Bezugszeichenliste**

10   Justieranlage
12   Messvorrichtung
14   Steuerungsvorrichtung
16   Projektionsobjektiv

| 18 | Beleuchtungseinrichtung |
|---|---|
| 20 | Messstrahlung |
| 22 | Messmaske |
| 24 | Objektebene |
| 26 | Sensorelement |
| 28 | Bildebene |
| 30 | Detektor |
| 32 | Auswerteeinrichtung |
| 34 | Zustandscharakterisierung |
| 34a | aktuelle Zustandscharakterisierung |
| 36 | Nachbearbeitungseinrichtung |
| 38 | Stellwegbefehl |
| 40 | Kippachse |
| 50 | Projektionsbelichtungsanlage |
| 52 | Belichtungsstrahlungsquelle |
| 54 | Belichtungsstrahlung |
| 56 | Beleuchtungsoptik |
| 58 | Maske |
| 60 | Maskenverschiebebühne |
| 62 | Scanrichtung der Maskenverschiebebühne |
| 64 | Substrat |
| 66 | Substratverschiebebühne |
| 68 | Scanrichtung der Substratverschiebebühne |
| 70 | Wellenfrontmesseinrichtung |
| 72 | zentrale Steuerungseinrichtung |
| 74 | aktuelle Bestrahlungsintensität |
| 76 | Drucksensor |
| 80 | Zustandsgeber |
| 82 | Speicher |
| 84 | Simulationseinrichtung |
| 86 | Stellwegermittler |
| 114 | Steuerungsvorrichtung |
| 138 | Stellwegbefehl |

L1 - L4    optische Elemente
M1 - M4    Manipulatoren
b    Zustandsvektor
$x_i$    Stellwege für Manipulatoren

$x_n^L$    Stellwege für ICA-Nachbearbeitungseinrichtung

Die Ansprüche der Erfindung folgen nachstehend.

**Patentansprüche**

1.  Steuerungsvorrichtung (14; 114) zur Steuerung mindestens eines Manipulators (M1, M2, M3, M4; 36) eines Projektionsobjektivs (16) für die Mikrolithographie durch Generierung eines Stellwegbefehls (38; 138), welcher eine vorzunehmende Veränderung einer optischen Wirkung mindestens eines optischen Elements (L1, L2, L3, L4) des Projektionsobjektivs durch Manipulation einer Eigenschaft des optischen Elements mittels des mindestens einen Manipulators entlang eines Stellweges definiert,
    wobei die Steuerungsvorrichtung dazu konfiguriert ist, aus einer Zustandscharakterisierung (34) des Projektionsobjektivs den Stellwegbefehl für den mindestens einen Manipulator durch Optimierung einer Gütefunktion zu generieren, wobei:

    die Gütefunktion eine Linearkombination mindestens zweier Potenzen umfasst, sowie
    eine die Manipulation der Eigenschaft des optischen Elements (L1, L2, L3, L4) definierende Einstellung des mindestens einen Manipulators (M1, M2, M3, M4; 36) mittels einer Stellwegvariablen dargestellt wird und die jeweilige Basis der mindestens zwei Potenzen eine Funktion der Stellwegvariablen enthält,
**dadurch gekennzeichnet, dass** die Exponenten der mindestens zwei Potenzen unterschiedliche Werte aufweisen.

2. Steuerungsvorrichtung nach Anspruch 1,
   bei der die mindestens zwei Potenzen unterschiedliche Basen aufweisen.

3. Steuerungsvorrichtung nach Anspruch 1 oder 2,
   bei der die Exponenten der mindestens zwei Potenzen Werte von jeweils größer oder gleich zwei aufweisen.

4. Steuerungsvorrichtung nach einem der vorausgehenden Ansprüche,
   bei der die jeweilige Basis der mindestens zwei Potenzen jeweils einen Quotienten enthält, dessen Zähler einen die Funktion der Stellwegvariablen enthaltenden Term umfasst und dessen Nenner einen Zielwert für den Term des Zählers sowie einen Gewichtungsfaktor für den Zielwert aufweist.

5. Steuerungsvorrichtung nach einem der vorausgehenden Ansprüche,
   bei der eine Differenz der Werte der beiden Exponenten mindestens fünf beträgt.

6. Steuerungsvorrichtung nach einem der vorausgehenden Ansprüche,
   welche zur Steuerung mehrerer Manipulatoren konfiguriert ist, die Zustandscharakterisierung (34) mehrere durch einen Zustandsvektor charakterisierte Zustandsparameter umfasst, und jeder der Potenzen eine Sensitivitätsmatrix (M) umfasst, welche einen Zusammenhang zwischen den Stellwegen der Manipulatoren und dem Zustandsvektor definiert.

7. Steuerungsvorrichtung nach einem der vorausgehenden Ansprüche,
   bei der eine der Potenzen einen Term umfasst, welcher einen Bildfehler des Projektionsobjektivs (16) beschreibt.

8. Steuerungsvorrichtung nach einem der vorausgehenden Ansprüche,
   bei der eine der Potenzen einen Term umfasst, welcher eine Fading-Aberration einer Step- und Scan Projektionsbelichtungsanlage (50) für die Mikrolithographie beschreibt.

9. Steuerungsvorrichtung nach einem der vorausgehenden Ansprüche,
   bei der eine der Potenzen einen Term umfasst, welcher einen quadratischen Mittelwert einer Auswahl von Bildfehlern des Projektionsobjektivs beschreibt.

10. Steuerungsvorrichtung nach einem der vorausgehenden Ansprüche,
    bei der eine der Potenzen einen Term umfasst, welcher einen reinen Overlay-Fehler beschreibt.

11. Steuerungsvorrichtung nach einem der vorausgehenden Ansprüche,
    bei der eine der Potenzen einen Term umfasst, welcher einen mittels mechanischer Nachbearbeitung eines optischen Elements (L1, L2, L3, L4) des Projektionsobjektivs korrigierbaren Fehler beschreibt.

12. Justieranlage (10) zur Justierung eines Projektionsobjektivs (16) für die Mikrolithographie,
    mit einer Messvorrichtung (12) zur Ermittlung der Zustandscharakterisierung (34) des Projektionsobjektivs, sowie einer Steuerungsvorrichtung (14) nach einem der vorausgehenden Ansprüche zur Generierung des Stellwegbefehls (38) aus der Zustandscharakterisierung.

13. Justieranlage nach Anspruch 12,
    bei der die Messvorrichtung als Wellenfrontmesseinrichtung konfiguriert ist.

14. Projektionsbelichtungsanlage (50) für die Mikrolithographie mit:

    - einem Projektionsobjektiv (16) zum Abbilden von Maskenstrukturen,
    - mindestens einem Manipulator (M1, M2, M3, M4), welcher dazu konfiguriert ist, eine optische Wirkung mindestens eines optischen Elements (L1, L2, L3, L4) des Projektionsobjektivs durch Manipulation einer Eigenschaft des optischen Elements entlang eines Stellweges zu verändern, sowie
    - einer Steuerungsvorrichtung (114) nach einem der Ansprüche 1 bis 12 zur Steuerung des mindestens einen Manipulators.

15. Verfahren zum Steuern mindestens eines Manipulators (M1, M2, M3, M4; 36) eines Projektionsobjektivs (16) für die Mikrolithographie mit den Schritten:

- Generieren eines Stellwegbefehls (38; 138) für den mindestens einen Manipulator durch Ausführen einer Optimierung einer Gütefunktion, wobei:

die Gütefunktion eine Linearkombination mindestens zweier Potenzen umfasst, sowie eine die Manipulation der Eigenschaft des optischen Elements definierende Einstellung des mindestens einen Manipulators mittels einer Stellwegvariablen dargestellt wird und die jeweilige Basis der mindestens zwei Potenzen eine Funktion der Stellwegvariablen enthält, sowie

- Verändern einer optischen Wirkung mindestens eines optischen Elements des Projektionsobjektivs (16) durch Manipulation einer Eigenschaft des optischen Elements mittels des mindestens einen Manipulators entlang eines durch den generierten Stellwegbefehl (38; 138) definierten Stellweges, **dadurch gekennzeichnet, dass** die Exponenten der mindestens zwei Potenzen unterschiedliche Werte aufweisen.

**Claims**

1. Control device (14; 114) for controlling at least one manipulator (M1, M2, M3, M4; 36) of a microlithographic projection lens (16) by generating a travel command (38; 138), which defines a change, to be undertaken, of an optical effect of at least one optical element (L1, L2, L3, L4) of the projection lens by manipulating a property of the optical element by means of the at least one manipulator along a travel, wherein the control device is configured to generate the travel command for the at least one manipulator from a state characterization (34) of the projection lens by optimizing a merit function, wherein:

the merit function comprises a linear combination of at least two exponential expressions, and a setting of the at least one manipulator (M1, M2, M3, M4; 36) defining the manipulation of the property of the optical element (L1, L2, L3, L4) is represented by means of a travel variable and the respective base of the at least two exponential expressions contains a function of the travel variable, **characterized in that** the exponents of the at least two exponential expressions have different values.

2. Control device according to Claim 1, wherein the at least two exponential expressions have different bases.

3. Control device according to Claim 1 or 2, wherein the exponents of the at least two exponential expressions have values each greater than or equal to two.

4. Control device according to one of the preceding claims, wherein the respective base of the at least two exponential expressions contains a quotient in each case, the numerator of which comprises a term containing the function of the travel variable and the denominator of which has a target value for the term of the numerator and a weighting factor for the target value.

5. Control device according to one of the preceding claims, wherein a difference in the values of the two exponents is at least five.

6. Control device according to one of the preceding claims, which is configured to control a plurality of manipulators, the state characterization (34) comprising a plurality of state parameters **characterized by** a state vector, and each of the exponential expressions comprising a sensitivity matrix (M) which defines a relationship between the travels of the manipulators and the state vector.

7. Control device according to one of the preceding claims, wherein one of the exponential expressions comprises a term which describes an image aberration of the projection lens (16).

8. Control device according to one of the preceding claims,
wherein one of the exponential expressions comprises a term which describes a fading aberration of a microlithographic step- and scan projection exposure apparatus (50).

9. Control device according to one of the preceding claims,
wherein one of the exponential expressions comprises a term which describes a root mean square of a selection of image aberrations of the projection lens.

10. Control device according to one of the preceding claims,
wherein one of the exponential expressions comprises a term which describes a pure overlay error.

11. Control device according to one of the preceding claims,
wherein one of the exponential expressions comprises a term which describes an error correctable by means of mechanical post-processing of an optical element (L1, L2, L3, L4) of the projection lens.

12. Adjustment apparatus (10) for adjusting a microlithographic projection lens (16),
comprising a measurement system (12) for establishing the state characterization (34) of the projection lens, and a control device (14) according to one of the preceding claims for generating the travel command (38) from the state characterization.

13. Adjustment apparatus according to Claim 12,
wherein the measurement system is configured as a wavefront measurement device.

14. Microlithographic projection exposure apparatus (50), comprising:

   - a projection lens (16) for imaging mask structures,
   - at least one manipulator (M1, M2, M3, M4), which is configured to change an optical effect of at least one optical element (L1, L2, L3, L4) of the projection lens by manipulating a property of the optical element along a travel, and
   - a control device (114) according to one of Claims 1 to 12 for controlling the at least one manipulator.

15. Method for controlling at least one manipulator (M1, M2, M3, M4; 36) of a microlithographic projection lens (16), comprising the following steps:

   - generating a travel command (38; 138) for the at least one manipulator by carrying out an optimization of a merit function, wherein:

      the merit function comprises a linear combination of at least two exponential expressions, and
      a setting of the at least one manipulator defining the manipulation of the property of the optical element is represented by means of a travel variable and the respective base of the at least two exponential expressions contains a function of the travel variable, and

   - changing an optical effect of at least one optical element of the projection lens (16) by manipulating a property of the optical element by means of the at least one manipulator along a travel defined by the generated travel command (38; 138),

   **characterized in that** the exponents of the at least two exponential expressions have different values.

## Revendications

1. Dispositif de commande (14; 114) destiné à commander au moins un manipulateur (M1, M2, M3, M4 ; 36) d'un objectif de projection (16) pour la microlithographie par génération d'une instruction de parcours de réglage (38 ; 138), laquelle définit une modification à effectuer d'un effet optique d'au moins un élément optique (L1, L2, L3, L4) de l'objectif de projection par manipulation d'une propriété de l'élément optique au moyen de l'au moins un manipulateur le long d'un parcours de réglage,

   le dispositif de commande étant configuré pour, à partir d'une caractérisation d'état (34) de l'objectif de projection, générer l'instruction de parcours de réglage pour l'au moins un manipulateur par optimisation d'une fonction de qualité,

la fonction de qualité comprenant une combinaison linéaire d'au moins deux puissances, et

un réglage de l'au moins un manipulateur (M1, M2, M3, M4 ; 36), qui définit la manipulation de la propriété de l'élément optique (L1, L2, L3, L4), étant représenté au moyen d'une variable de parcours de réglage et la base respective des au moins deux puissances contenant une fonction de la variable de parcours de réglage, **caractérisé en ce que** les exposants des au moins deux puissances possèdent des valeurs différentes.

2. Dispositif de commande selon la revendication 1, avec lequel les au moins deux puissances possèdent des bases différentes.

3. Dispositif de commande selon la revendication 1 ou 2, avec lequel les exposants des au moins deux puissances possèdent des valeurs respectivement supérieures ou égales à deux.

4. Dispositif de commande selon l'une des revendications précédentes, avec lequel la base respective des au moins deux puissances contient respectivement un quotient dont le compteur comporte un terme contenant la fonction de la variable de parcours de réglage et dont le dénominateur possède une valeur cible pour le terme du compteur ainsi qu'un facteur de pondération pour la valeur cible.

5. Dispositif de commande selon l'une des revendications précédentes, avec lequel la différence des valeurs des deux exposants est au moins égale à cinq.

6. Dispositif de commande selon l'une des revendications précédentes, lequel est configuré pour la commande de plusieurs manipulateurs, la caractérisation d'état (34) comprend plusieurs paramètres d'état **caractérisés par** un vecteur d'état, et chacune des puissances comprend une matrice de sensibilité (M) qui définit une relation entre le parcours de réglage des manipulateurs et le vecteur d'état.

7. Dispositif de commande selon l'une des revendications précédentes, avec lequel l'une des puissances comprend un terme qui décrit une distorsion optique de l'objectif de projection (16).

8. Dispositif de commande selon l'une des revendications précédentes, avec lequel l'une des puissances comprend un terme qui décrit une aberration d'évanouissement d'un équipement d'éclairage par projection (50) par paliers et balayage pour la microlithographie.

9. Dispositif de commande selon l'une des revendications précédentes, avec lequel l'une des puissances comprend un terme qui décrit une moyenne quadratique d'une sélection de distorsions optiques de l'objectif de projection.

10. Dispositif de commande selon l'une des revendications précédentes, avec lequel l'une des puissances comprend un terme qui décrit une erreur de superposition.

11. Dispositif de commande selon l'une des revendications précédentes, avec lequel l'une des puissances comprend un terme qui décrit une erreur qui peut être corrigée au moyen d'une reprise mécanique d'un élément optique (L1, L2, L3, L4) de l'objectif de projection.

12. Équipement d'ajustement (10) destiné à ajuster un objectif de projection (16) pour la microlithographie, comprenant un dispositif de mesure (12) destiné à déterminer la caractérisation d'état (34) de l'objectif de projection, ainsi qu'un dispositif de commande (14) selon l'une des revendications précédentes destiné à générer l'instruction de parcours de réglage (38) à partir de la caractérisation d'état.

13. Équipement d'ajustement selon la revendication 12, avec lequel le dispositif de mesure est configuré sous la forme d'un appareil de mesure de front d'onde.

14. Équipement d'éclairage par projection (50) pour la microlithographie, comprenant :

- un objectif de projection (16) destiné à représenter des structures de masque,
- au moins un manipulateur (M1, M2, M3, M4), lequel est configuré pour modifier un effet optique d'au moins un élément optique (L1, L2, L3, L4) de l'objectif de projection par manipulation d'une propriété de l'élément optique le long d'un parcours de réglage, et

- un dispositif de commande (114) selon l'une des revendications 1 à 12 pour commander l'au moins un manipulateur.

15. Procédé de commande d'au moins un manipulateur (M1, M2, M3, M4 ; 36) d'un objectif de projection (16) pour la microlithographie, comprenant les étapes suivantes :

- génération d'une instruction de parcours de réglage (38 ; 138) pour l'au moins un manipulateur en réalisant une optimisation d'une fonction de qualité,

la fonction de qualité comprenant une combinaison linaire d'au moins deux puissances, et
un réglage de l'au moins un manipulateur, qui définit la manipulation de la propriété de l'élément optique, étant représenté au moyen d'une variable de parcours de réglage et la base respective des au moins deux puissances contenant une fonction de la variable de parcours de réglage, ainsi que

- modification d'un effet optique d'au moins un élément optique de l'objectif de projection (16) par manipulation d'une propriété de l'élément optique au moyen de l'au moins un manipulateur le long d'un parcours de réglage défini par l'instruction de parcours de réglage (38 ; 138) générée,
**caractérisé en ce que** les exposants des au moins deux puissances possèdent des valeurs différentes.

# Fig. 1

Fig. 2

EP 3 079 016 B1

# Fig. 3

26

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010034674 A1

- DE 102012205096 B3

**In der Beschreibung aufgeführte Nicht-Patentliteratur**

- **VON H. GROSS.** Handbook of Optical Systems. Wiley-VCH Verlag GmbH & Co. KGaA, 2005, vol. 2, 215